# EUROPÄISCHE PATENTSCHRIFT

(11) **EP 0 903 792 B1**
(45) Veröffentlichungstag und Bekanntmachung des Hinweises auf die Patenterteilung: **03.11.2010**
(21) Anmeldenummer: 98117796.7
(22) Anmeldetag: 18.09.1998
(51) Int. Cl.: H01S 5/02, H01L 33/00

(54) **Verfahren zum Herstellen einer Mehrzahl von Halbleiterlasern**
Method of manufacturing a plurality of semiconductor lasers
Procédé pour la réalisation d'une pluralité de lasers semi-conducteurs

(30) Priorität: 19.09.1997 DE 19741442; 26.08.1998 DE 19838810
(43) Veröffentlichungstag der Anmeldung: 24.03.1999
(73) Patentinhaber: OSRAM Opto Semiconductors GmbH, 93055 Regensburg (DE)
(72) Erfinder: Härle, Volker, Dr., 93164 Waldetzenberg (DE)
(74) Vertreter: Epping - Hermann - Fischer

(56) Entgegenhaltungen:
- EP-A- 0 599 224
- EP-A- 0 743 727
- JP-A- 2 260 416
- US-A- 5 478 774
- PATENT ABSTRACTS OF JAPAN vol. 1997, no. 06, 30. Juni 1997 (1997-06-30) & JP 09 045987 A (HITACHI LTD), 14. Februar 1997 (1997-02-14)
- PATENT ABSTRACTS OF JAPAN vol. 1995, no. 08, 29. September 1995 (1995-09-29) & JP 07 122520 A (NICHIA CHEM IND LTD), 12. Mai 1995 (1995-05-12)
- PATENT ABSTRACTS OF JAPAN vol. 018, no. 008 (E-1486), 7. Januar 1994 (1994-01-07) & JP 05 251738 A (FUJITSU LTD), 28. September 1993 (1993-09-28)
- NAM O -H ET AL: "GROWTH OF GAN AND AL0.2GA0.8N ON PATTERENED SUBSTRATES VIA ORGANOMETALLIC VAPOR PHASE EPITAXY" JAPANESE JOURNAL OF APPLIED PHYSICS,JP,PUBLICATION OFFICE JAPANESE JOURNAL OF APPLIED PHYSICS. TOKYO, Bd. 36, Nr. 5A, Seite L532-L535 XP000728854 ISSN: 0021-4922
- PATENT ABSTRACTS OF JAPAN vol. 1996, no. 06, 28. Juni 1996 (1996-06-28) & JP 08 046291 A (MATSUSHITA ELECTRIC IND CO LTD), 16. Februar 1996 (1996-02-16)
- NAGAHARA M ET AL: "SELECTIVE GROWTH OF CUBIC GAN IN SMALL AREAS ON PATTERNED GAAS(100)SUBSTRATES BY METALORGANIC VAPOR PHASE EPITAXY" 1 January 1994 (1994-01-01), JAPANESE JOURNAL OF APPLIED PHYSICS, JAPAN SOCIETY OF APPLIED PHYSICS, TOKYO,JP, PAGE(S) 694 - 697 , XP000596419 ISSN: 0021-4922 * the whole document *
- ORENSTEIN M ET AL: "TRANSVERSE MODES AND LASING CHARACTERISTICS OF SELECTIVELY GROWN VERICAL CAVITY SEMICONDUCTOR LASERS" 23 September 1996 (1996-09-23), APPLIED PHYSICS LETTERS, AIP, AMERICAN INSTITUTE OF PHYSICS, MELVILLE, NY, US, PAGE(S) 1840 - 1842 , XP000628919 ISSN: 0003-6951

## Beschreibung

Die Erfindung bezieht sich auf ein Verfahren zum Herstellen einer Mehrzahl von Halbleiterkörpern, insbesondere von strahlungsemittierenden Halbleiterköpern.

Sie bezieht sich insbesondere auf ein Verfahren zum Herstellen einer Mehrzahl von kantenemittierenden Halbleiterlaserchips, die an mindestens zwei einander gegenüberliegenden Seitenflächen planparallel zueinander liegende Laserspiegelflächen aufweisen.

Derartige Verfahren sind bekannt. Zur Herstellung von Lumineszenzdiodenchips wird zum Beispiel auf einem Halbleitersubstratwafer eine elektrolumineszierende Halbleiterschichtenfolge epitaktisch aufgewachsen. Dieser sogenannte Epi-Wafer wird nachfolgend, nachdem er mit den erforderlichen Kontaktmetallisierungen zur elektrischen Kontaktierung der Lumineszenzdiodenchips versehen ist, mittels Sägen zu Lumineszenzdiodenchips zerteilt. Ähnliche Verfahren werden bei Transistor-, IC-Chips usw. verwendet.

In der EP 0 599 224 A1 ist ein Verfahren beschrieben, bei dem eine Mehrzahl von InₓGa₁₋ₓN-Schichten auf einem Substrat epitaktisch abgeschieden werden. Diese Mehrzahl von InₓGa₁₋ₓN-Schichten bilden eine Leuchtdioden(LED)-Schichten-folge, die sich über den gesamten Wafer erstreckt. Nach dem Abscheiden der LED-Schichtenfolge, deren Strukturierung mittels Ätzen und dem Aufbringen einer Mehrzahl von Kontaktmetallisierungen wird der Wafer in eine Vielzahl von einzelnen Leuchtdiodenchips vereinzelt, indem der Wafer zwischen den Kontaktmetallisierungen beispielsweise mittels Sägen durchtrennt wird.

Bei der Abscheidung von Ga(In,Al)N-Leuchtdiodenstrukturen besteht unabhängig vom Substratmaterial das besondere Problem stark abweichender Gitterkonstanten der Nitride zu den entsprechenden Substraten. Eine weitere Schwierigkeit stellen die stark unterschiedlichen thermischen Ausdehnungskoeffizienten der zur Verfügung stehenden Substratmaterialien (z. B. Saphir oder SiC) und des Systems Ga(In,Al)N dar. Die dadurch hervorgerufenen unterschiedlichen thermischen Ausdehnungen bewirken, daß beim Abkühlen des Wafers von der Wachstumstemperatur auf Raumtemperatur im Wafer thermisch induzierte Verspannungen auftreten. Dies führt zu Defekten in den Halbleiterstrukturen, in erster Linie "Cracks", Löcher etc., die die Bauelementeigenschaften wie ESD-Stabilität, Lebensdauer usw. nachhaltig beeinträchtigen. Unter Ga(In,Al)N ist Ga_{1-x-y}InₓAl_{y}N mit 0≤x<1, 0≤y<1 und x+y<1 zu verstehen.

Ein weiteres Problem, das bei Ga(In,Al)N-Leuchtdiodenstrukturen auftritt, besteht darin, daß dieses Materialsystem chemisch sehr stabil ist. Diese Eigenschaft wirft große Probleme bei der Bauelementstrukturierung auf. Strukturierungen der Ga(In,Al)N-Schichtenfolgen auf dem Wafer sind nur mittels technisch aufwendiger Methoden, wie Trockenätzverfahren oder UV-unterstützte naßchemische Ätzverfahren, möglich.

Außerdem können beispielsweise Saphir und GaN wegen ihrer großen Härte nur mit großem technischen Aufwand gesägt werden.

In der Druckschrift JP 07 122 520 wird ein Verfahren zum Herstellen eines Galliumnitrid-Verbindungshalbleiterchips beschrieben, bei dem das Galliumnitrid-Halbleitermaterial selektiv in den Öffnungen einer Maskenschicht abgeschieden wird.

Die Druckschrift JP 02 260 416 beschreibt ein Verfahren, bei dem ein Halbleiterlaser auf der Basis eines Arsenid-Halbleiters in Gräben einer SiO₂-Maskenschicht aufgewachsen wird.

Bei einem bekannten Verfahren zur Herstellung von kantenemittierenden Laserdioden wird zur Realisierung der Laserspiegel beispielsweise ein die Laserdiodenstrukturen aufweisender Epi-Halbleiterwafer entsprechend den kristallographichen Richtungen des Substrats gespalten.

Die Herstellung von aus Halbleitermaterialien unterschiedlichster Art bestehenden Halbleiterkörpern auf verschiedensten Substratkristallen erlaubt immer weniger die Nutzung kristallographischer Richtungen des Substrates zur Herstellung von Laserspiegeln durch einfaches Spalten. Aufwendige Techniken, wie Naß- oder Trockenätzverfahren werden daher notwendig, um Laserspiegel exakt planparallel und mit geringer Rauhigkeit zu realisieren. Verschiedene Halbleitermaterialsysteme, wie beispielsweise Ga(In,Al)N haben sogar die Eigenschaft, gegen übliche naßchemische Ätzen resistent zu sein. In diesen Fällen ist man völlig auf technisch aufwendige und damit teure Trockenätzverfahren angewiesen.

Die Aufgabe der vorliegenden Erfindung besteht darin, ein Verfahren der eingangs genannten Art anzugeben, das es ermöglicht, auch bei der Verwendung von mechanisch und chemisch sehr stabilen Halbleitermaterialien und/oder von Substrat- und Epitaxieschichtmaterialien mit stark voneinander abweichenden Gitterkonstanten auf einfache Weise eine Mehrzahl von Halbleiterkörpern mit genau definierten Seitenflächen und/oder reduzierten Kristallstörungen herzustellen.

Es soll insbesondere ein einfaches Verfahren zum Herstellen von Laserspiegeln eines kantenemittierenden Laser-Halbleiterkörpers, insbesondere bestehend aus verschiedenen Halbleiterschichten aus dem Materialsystem Ga(In,Al)N, angegeben werden.

Diese Aufgabe wird durch ein Verfahren mit den Merkmalen des Anspruches 1 gelöst. Vorteilhafte Weiterbildungen des Verfahrens zum Herstellen von kantenemittierenden Ga(In,Al)N-Halbleiterlaserchips sind Gegenstand der Unteransprüche 2 bis 10.

Bei dem Verfahren wird vorzugsweise zunächst auf den Substratwafer eine gut ätzbare Maskenschicht aufgebracht, die nachfolgend beispielsweise mittels Phototechnik mit einer Mehrzahl von Maskenöffnungen (Fenstern) versehen wird, in denen die Hauptfläche des Substratwafers freigelegt ist. Nachfolgend wird die Halbleiterschichtenfolge von Halbleiterlaserstrukturen in den Fenstern auf der Hauptfläche des Substratwafers abgeschieden. Die Fenster definieren hierbei die laterale Form der Halbleiterschichtenfolge. Nach einem Aufbringen von Kontaktmetallisierungen auf den derart hergestellten Wafer wird dieser in einzelne Halbleiterlaserchips vereinzelt.

Als Maskenschicht dient vorteilhafterweise eine dielektrische Schicht aus SiO₂ oder SiₓN₁₋ₓ und die Fenster werden beispielsweise mittels eines isotropen naßchemischen Ätzverfahrens (z. B. mit herkömmlicher Fensterätzlösung) oder mittels eines trockenchemischen Ätzverfahrens hergestellt, das vorzugsweise gegenüber dem Substratmaterial selektiv ist.

Besonders bevorzugt wird das Verfahren bei Halbleiterkörpern eingesetzt, bei denen das Substrat aus SiC, Saphir oder GaN besteht und bei denen die Halbleiterschichtenfolge mindestens eine Halbleiterschicht aus dem Materialsystem Ga(In,Al)N aufweist.

Insbesondere sind dies kantenemittierende Laserdioden, die mindestens eine Halbleiterschicht aus dem Materialsystem der auf GaN-basierenden III-V-Verbindungshalbleiter, wie z.B. Ga_{1-x-y}InₓAl_{y}N mit 0≤x<1, 0≤y<1 und x+y<1, aufweisen, weil hier die eingangs erwähnten Probleme in besonderem Maße zur Geltung kommen.

Dies sind beispielsweise blaues oder grünes Licht aussendende Laserdioden, bei denen als Halbleiterschichtenfolge eine kantenemittierende Laser-Halbleiterstruktur vorgesehen ist, die an zwei einander gegenüberliegenden Seitenflächen planparallel zueinander liegende Laserspiegelflächen aufweist. Die Laserspiegel werden bei dem erfindungsgemäßen Verfahren durch zwei einander exakt planparallel gegenüberliegende Seitenflächen der Maskenöffnungen definiert.

Bei der Herstellung von kantenemittierenden Halbleiterlaserchips wird vorzugsweise die Maskenschicht wieder entfernt, bevorzugt durch selektives Ätzen (selektiv zur Halbleiterschichtenfolge).

Zur Vereinzelung des so erzeugten Wafers in einzelne Chips wird nur noch die Maskenschicht (falls diese nicht vorher entfernt wurde), der Substratwafer und ggf. eine auf der Rückseite (= die von den Laserdiodenstrukturen abgewandte Hauptfläche des Substratwafers) aufgebrachte Kontaktmetallisierung zwischen den Laserdiodenstrukturen durchtrennt werden. Damit kommt es bei diesem Verfahren vorteilhafterweise zu keiner Beschädigung der Halbleiterschichtenfolgen beim Sägen und/oder Brechen des Wafers.

Diese optionale Entfernen der Maskenschicht nach dem Abscheiden von Laserdiodenstrukturen erfolgt beispielsweise mittels eines naßchemischen Ätzverfahrens, bei dem die Laserdiodenstrukturen überhaupt nicht oder nur in sehr geringem Umfang abgetragen werden.

Ein Vorteil des Verfahrens besteht einerseits darin, daß die Form und Dimension der späteren Halbleiterlaserchips vor der Epitaxie der Halbleiterschichtenfolge dieser Chips definiert werden, wodurch gegenüber den bekannten Verfahren mehrere Prozeßschritte eingespart werden können.

Andererseits ermöglicht dieses Verfahren vorteilhafterweise die Abscheidung stark verspannter Strukturen in den vordefinierten Fenstern. Der abgeschiedene Kristall besitzt hierbei die Möglichkeit, sich in drei Raumrichtungen auszudehnen und somit die potentielle Verspannungsenergie im Volumen abzubauen, ohne entsprechende Versetzungen ausbilden zu müssen.

Weiterhin werden vorteilhafterweise weniger Defekte in den Kristall eingebaut, da bereits während des Wachstums Verspannungen in den kristallinen Schichten abgebaut werden können.

Im Fall der weiter oben beschriebenen bekannten planaren Epitaxie (ohne Maske) werden im Kristall zum Abbau der potentiellen Verspannungsenergie Defekte erzeugt. Diese Defekte beeinträchtigen nachhaltig das spätere Bauelement in der Art, daß beispielsweise die Lebensdauer verkürzt und/oder die ESD-Stabilität deutlich reduziert ist. Eine Reduzierung der Defekte mittels des erfindungsgemäßen Verfahrens äußert sich demzufolge direkt in einer Verbesserung dieser Bauelementeigenschaften.

Ein wesentliches Merkmal des vorliegenden Verfahrens besteht in der selektiven Abscheidung der Halbleiterlaserstrukturen in den Maskenöffnungen (Fenstern). Die Maskenschicht sowie die Abscheidebedingungen können derart gewählt werden, daß auf der Maske eine epitaktische, d. h. einkristalline Abscheidung von Ga(In,Al)N-Material nicht erfolgt.

Anwendbar ist dieses Verfahren sowohl auf Saphir als auch auf SiC, Si, GaAs, GaN, AlN etc. als Aufwachs-Substratmaterial. Viele Schwierigkeiten, die beim Brechen bzw. Ätzen von mittels planarer Epitaxie hergestellten Scheiben, insbesondere von Ga(in,Al)N-Epitaxiewafern zur Herstellung von Halbleiterlaserchips verschiedenster Art auftreten, werden mit diesem Verfahren umgangen.

Bei einer bevorzugten Ausführungsform des Verfahrens wird vor dem Aufbringen der Maskenschicht auf einem Aufwachs-Substratwafer eine Pufferschicht, z. B. bestehend aus Ga(In,Al)N, aufgewachsen. Auf dieser werden dann in nachfolgenden Prozessschritten die Maskenschicht und die Halbleiterschichtenfolgen für die Halbleiterlaserstrukturen abgeschieden. Dies kann vorteilhafterweise die Aufwachsbedingungen für die Halbleiterschichtenfolgen verbessern.

Ein wesentlicher Vorteil des erfindungsgemäßen Verfahrens bei der Herstellung von kantenemittierenden Halbleiterlaserchips besteht darin, dass die Definition der Laserspiegel bereits vor der epitaktischen Abscheidung der Halbleiterschichtfolge stattfindet. Die Maskenschicht weist hierbei vorzugsweise mindestens eine Dicke auf, die dem lichtführenden Bereich des vorgesehenen Laser-Halbleiterkörpers entspricht und vertikal im Bereich der Lichtentstehung im vorgesehenen Laser-Halbleiterkörper angesiedelt ist. Mit Hilfe von naß- oder trockenchemischen Ätzverfahren werden die Laserspiegel und, soweit möglich, alle anderen notwendigen Begrenzungen der Halbleiterschichtenfolge in diese Schicht geätzt, wobei auf möglichst scharfe Ätzkanten und glatte Ätzflanken zu achten ist. Die spätere laterale Form der Halbleiterschichtenfolge des Halbleiterlaserchips wird bereits bei diesem Prozeß in ihren geometrischen Verhältnissen definiert.

In den entstehenden Ätzfenstern wird das Substratmaterial freigelegt, das einer anschließenden Epitaxie als Substratfläche dient. Durch selektive Epitaxie, bei der die Halbleitermaterialien der Halbleiterschichtfolge nur auf der Oberfläche des Substratwafers in den Fenstern abgeschieden werden, wird dann die Laserstruktur, insbesondere der lichtführende sowie der aktive Bereich des Laser-Halbleiterkörpers hergestellt.

Nach Abschluß der Epitaxie wird die gut ätzbare Schicht durch Ätzen mit geeigneten Chemikalien naß- oder trockenchemisch entfernt. Die dadurch erzeugte Struktur besitzt nun bereits die geometrischen Umrisse des Laser-Halbleiterkörpers mit sehr gut definierten Laserspiegeln.

Das Verfahren wird im folgenden anhand von drei Ausführungsbeispielen in Verbindung mit den Figuren 1 bis 10 näher erläutert.

Die Figuren 1 bis 6 zeigen schematisch einen Verfahrensablauf zur Herstellung von Leuchtdioden der nur zur Illustration der Erfindung dient.
In Figur 7 ist schematisch ein Leuchtdiodenchip dargestellt, der nach einem Verfahren gemäß der Illustration gefertigt ist und nicht der Erfindung entspricht.
Die Figuren 8 bis 10 zeigen schematisch einen Verfahrensablauf zur Herstellung eines kantenemittierenden Laser-Halbleiterkörpers gemäß der Erfindung.

In den Figuren sind gleiche oder gleichwirkende Bestandteile jeweils mit denselben Bezugszeichen versehen.

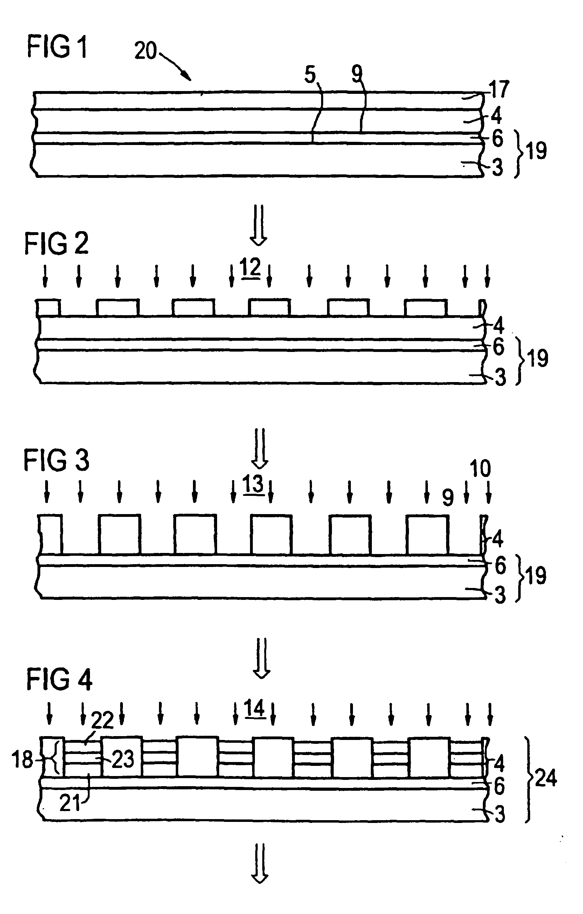

### Illustratives Beispiel gemäß den Figuren 1 bis 6:

Zunächst wird auf eine Hauptfläche 5 eines bevorzugt aus SiC bestehenden Aufwachs-Substratwafers 3 beispielsweise mittels MOVPE (Metallorganische Dampfphasenepitaxie) eine elektrisch leitfähige Halbleiterschicht 6 (z.B. eine Bufferschicht) aufgebracht, die z. B. aus GaN und/oder AlGaN besteht. Auf diesen aus dem Aufwachs-Substrat 3 und der Halbleiterschicht 6 bestehenden Substratwafer 19 wird nachfolgend eine Maskenschicht 4, beispielsweise bestehend aus SiO₂ oder SiₓN₁₋ₓ, aufgebracht, auf der wiederum eine Photolackschicht 17 abgeschieden wird. Der auf diese Weise hergestellte Wafer 20 ist in Figur 1 schematisch dargestellt.

Nach einer herkömmlichen phototechnischen Strukturierung der Photolackschicht 17 wird die Maskenschicht 4 beispielsweise auf eine an sich bekannte Art und Weise mittels eines isotropen naßchemischen (z. B. Photo-Ätzlösung) oder mittels eines trockenchemischen Ätzverfahrens 12 (Figur 2), das bevorzugt zum Material der Halbleiterschicht 6 selektiv ist, mit einer Mehrzahl von Maskenöffnungen 10 (Fenstern) versehen, derart, daß in den Maskenöffnungen 10 die vom Aufwachs-Substrat 3 abgewandte Hauptfläche 9 der Halbleiterschicht 6 freigelegt ist (Figur 3).

Bei einem nachfolgenden Verfahrensschritt wird beispielsweise mittels metallorganischer Dampfphasenepitaxie (MOVPE) 13 (Figur 3) auf die in den Fenstern 10 freigelegte Hauptfläche 9 der Halbleiterschicht 6 eine Ga(In,Al)N-Halbleiterschichtenfolge 18 (Figur 4), bestehend aus einer Mehrzahl von Ga(In,Al)N-Schichten selektiv epitaktisch abgeschieden. Unter "selektiv epitaktisch" ist in diesem Zusammenhang zu verstehen, daß das Halbleitermaterial der Leuchtdiodenstruktur nur auf der Hauptfläche 9 der Halbleiterschicht 6 und nicht auf der Maskenschicht 4 epitaktisch, d. h. einkristallin abgeschieden wird. Auf der Maskenschicht 4 erfolgt, wenn überhaupt, nur ein polykristallines Wachstum.

Die Ga(In,Al)N-Halbleiterschichtenfolge 18 weist beispielsweise eine zwischen einer n-dotierten 21 und einer p-dotierten Ga_{y}Al_{1-y}N(0≤y≤1)-Mantelschicht 22 angeordnete lichtemittierende aktive Schicht 23 auf, die aus n-dotiertem InₓGa₁₋ₓN (0<x<1) besteht.

Die Zusammensetzungen, Schichtdicken, Dotierungen etc. der einzelnen Schichten von Ga(In,Al)N-Halbleiterschichtenfolgen 18 für Leuchtdiodenchips 100 sind in der Halbleitertechnik bekannt und werden daher an dieser Stelle nicht näher erläutert. Gleiches gilt für die Ätzverfahren zum isotropen und anisotropen Ätzen von Sio₂ und SiₓN₁₋ₓ.

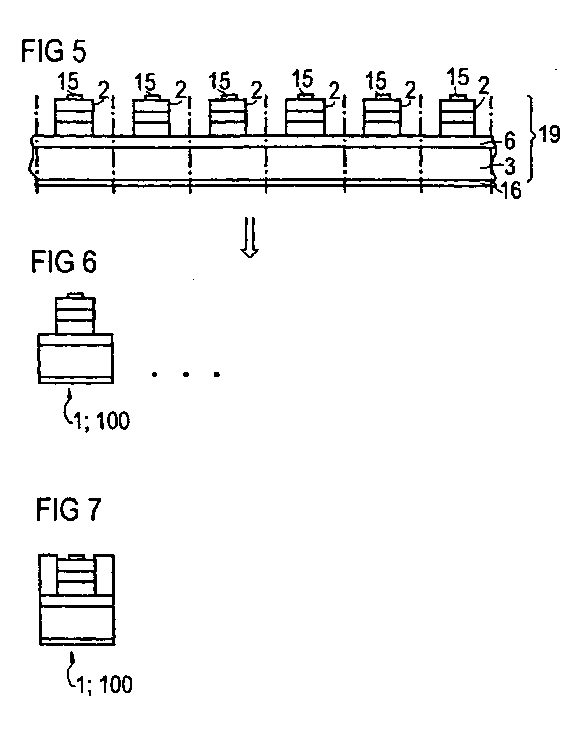

Nach der selektiven Epitaxie der Ga(In,Al)N-Halbleiterschichtenfolge 18 wird, wie in Figur 4 dargestellt, die Maskenschicht 4 mittels einer zur Ga(In,Al)N-Halbleiterschich-tenfolge 18 selektiven naßchemischen oder trockenchemischen Ätzung 14 von dem vorliegenden Wafer 24 (genauer, von der Hauptfläche 9 der Halbleiterschicht 6) entfernt, so daß freistehende Leuchtdiodenstrukturen 2 auf dem Substratwafer 19 zurückbleiben (Figur 5).

Zur Kontaktierung der Leuchtdiodenstrukturen 2 müssen, wie in Figur 5 gezeigt, auf diese noch Vorderseiten-Kontaktmetallisierungen 15 aufgebracht werden. Dieser Schritt erfolgt vorteilhafterweise vor dem Entfernen der Maskenschicht 4 z. B. mittels Phototechnik und Metallisierung. Hierzu kann wiederum ein in der Halbleitertechnik herkömmliches Metallisierungsverfahren eingesetzt werden.

Ebenso wird die von den Leuchtdiodenstrukturen 2 abgewandte Seite des Substratwafers 3 vor oder nach dem Prozessieren der Leuchtdiodenstrukturen 2 mit einer Rückseiten-Kontaktmetallisierungsschicht 16 versehen.

Danach wird der Substratwafer 19 mit Rückseiten-Kontaktmetallisierungsschicht 16 zwischen den Leuchtdiodenstrukturen 2 durchtrennt, so daß einzelne Leuchtdiodenchips 100 entstehen (Figur 6).

Bei dem Verfahren muß nicht notwendigerweise vor dem Aufbringen der Maskenschicht 4 eine Halbleiterschicht 6 auf das Aufwachs-Substrat 3 aufgebracht werden. Vielmehr kann die Maskenschicht 4 direkt auf die Hauptfläche 5 des Aufwachs-Substrats 3, das dann alleine den Substratwafer 19 bildet, abgeschieden werden. Die selektive Epitaxie der Leuchtdiodenstrukturen 2 gegebenenfalls inclusive Bufferschicht erfolgt dann nach dem Herstellen der Fenster 10 in der Maskenschicht 4 ebenfalls auf der Hauptfläche 5 des Aufwachs-Substrats 3.

Auf ähnliche Weise können VCSEL(Vertical Cavity Surface Emitting Laser)-Chips hergestellt werden.

### Illustratives Beispiel gemäß Figur 7:

Hier wird die Maskenschicht 4 vor dem Vereinzeln des Wafers 24 zu einzelnen Leuchtdiodenchips 100 nicht entfernt, so daß die Leuchtdiodenchips 100, wie in Figur 7 dargestellt, neben der Leuchtdiodenstruktur 2 nach dem Vereinzeln des Wafers mit der Maskenschicht 4 versehen sind. Dadurch kann vorteilhafterweise ein Ätzschritt eingespart werden.

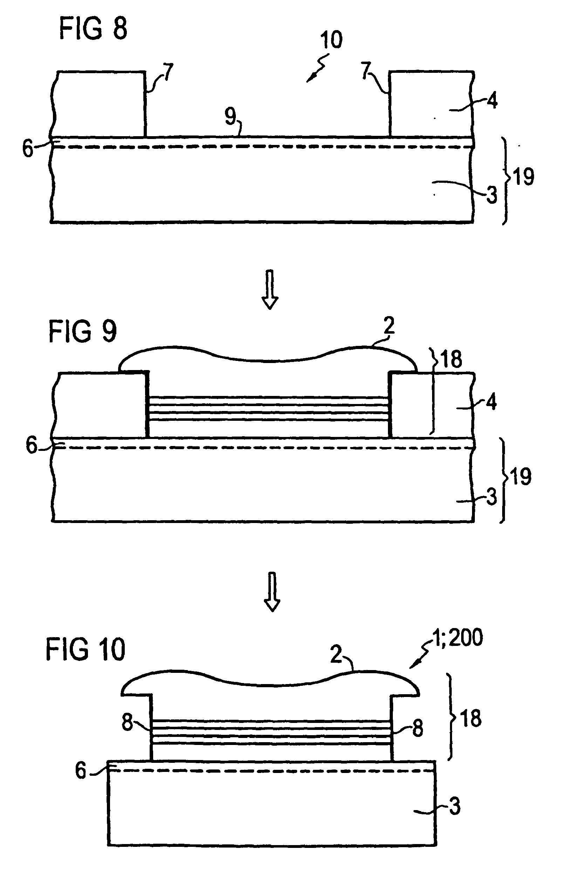

### Ausführungsbeispiel gemäß den Figuren 8 bis 10:

Zunächst wird auf eine Hauptfläche 9 eines Substratwafers 19, auf dem bereits eine Halbleiterschicht 6 aufgebracht sein kann (in den Figuren gestrichelt angedeutet), ganzflächig eine Maskenschicht 4 aufgebracht. Das Aufwachs-Substrat 3 besteht beispielsweise aus SiC oder Saphir und die Maskenschicht 4 aus SiO₂ oder SiₓN₁₋ₓ. Die Halbleiterschicht 6 ist ggf. beispielsweise eine AlₓGa₁₋ₓN-Epitaxieschicht (0 ≤ x ≤ 1) und dient z. B. als Bufferschicht.

Nachfolgend werden beispielsweise mittels Naß- oder Trockenätzen in der Maskenschicht 4 eine Mehrzahl von Fenster 10 (z.B. eine runde, rechteckige oder quadratische Ausnehmung oder Graben) augebildet, in denen die Hauptfläche 9 des Substratwafers 19 freigelegt ist. Ätzmittel zum Ätzen von SiO₂ oder SiₓN₁₋ₓ sind ind er Halbleitertechnik bekannt und werden von daher an dieser Stelle nicht näher erläutert.

Beim nächsten Schritt wird auf die freigelegte Hauptfläche 9 des Substratwafers 19 mittels selektiver Epitaxie eine Halbleiterschichtenfolge 2 einer kantenemittierenden Laserstruktur auf der Basis von Ga(In,Al)N aufgebracht. Die Fenster 10 weisen jeweils zwei einander gegenüberliegende planparallele Seitenflächen 7 auf, die die beiden planparallel zueinander liegenden Laserspiegelflächen 8 der kantenemittierenden Laserstrukturen 2 definieren.

Selektive Epitaxie bedeutet, daß das Halbleitermaterial der Halbleiterschichtenfolge nur auf der Substratoberfläche und nicht auf der Maskenschicht epitaktisch, d.h. einkristallin abgeschieden wird.

Das Fenster 10 wird mittels eines ersten bzgl. des Substratwafers 19 selektiven Ätzschrittes ausgebildet und die Maskenschicht 4 wird mittels eines zweiten bzgl. der Halbleiterschichtenfolge 2 selektiven Ätzschrittes entfernt.

Abschließend wird die Maskenschicht 4 beispielsweise mittels naß- oder trockenchemischer Ätzung vom Substratwafer 19 entfernt, so daß die Halbleiterschichtenfolge 2 als Laser-Halbleiterkörper freistehend auf dem Substrat 3 verbleibt. Der so erzeugte Wafer wird dann zu kantenemittierenden Laserchips 200 vereinzelt.

Die Beschreibung des erfindungsgemäßen Verfahrens anhand dieses Ausführungsbeispiels ist selbstverständlich nicht als Beschränkung der Erfindung auf dieses Beispiel zu verstehen. Der Fachmann kann das Verfahren überall dort einsetzen, wo die eingangs geschilderten Probleme auftreten.

## Patentansprüche

1. Verfahren zum Herstellen einer Mehrzahl von kantenemittierenden Halbleiterlaserchips (200), bei dem:
- auf einen Substratwafer (19) eine Maskenschicht (4) aufgebracht wird,
- die Maskenschicht (4) mit einer Mehrzahl von Fenstern (10) versehen wird, in denen die Hauptfläche (9) des Substratwafers (19) freigelegt ist,
- eine auf Ga(Al,In)N basierende Halbleiterschichtenfolge (18) auf die in den Fenstern (10) freigelegte Hauptfläche (9) des Substratwafers (19) abgeschieden wird, so dass in den Fenstern (10) gleichartige kantenemittierende Laserstrukturen erzeugt werden, und
- der so hergestellte Wafer (24) mittels Durchtrennen zwischen den kantenemittierenden Laserstrukturen zu kantenemittierenden Halbleiterlaserchips (200) vereinzelt wird,
wobei die Maskenschicht (4) mindestens eine Dicke aufweist, die dem lichtführenden Bereich der kantenemittierenden Laserstrukturen entspricht, so dass die Laserspiegelflächen (8) der kantenemittierenden Laserstrukturen jeweils durch zwei einander gegenüberliegende planparallele Seitenflächen (7) der Fenster (10) definiert werden.

2. Verfahren nach Anspruch 1,
bei dem als Maskenschicht (4) eine SiO₂- oder SiₓN₁₋ₓ-Schicht verwendet wird.

3. Verfahren nach einem der Ansprüche 1 oder 2,
bei dem der Substratwafer (19) mindestens eine epitaktisch aufgebrachte Halbleiterschicht (6) aufweist, auf die in den Fenstern (10) die Halbleiterschichtenfolge (18) abgeschieden wird.

4. Verfahren nach Anspruch 3,
bei dem die Halbleiterschicht (6) im wesentlichen aus GaₓAl₁₋ₓN (0≤x≤1) besteht.

5. Verfahren nach einem der Ansprüche 1 bis 4,
bei dem die Halbleiterschichtenfolge mindestens eine Halbleiterschicht aus Ga_{1-x-y}InₓAl_{y}N mit 0≤x<1, 0≤y<1 und x+y<1, aufweist.

6. Verfahren nach einem der Ansprüche 1 bis 5,
bei dem zum Ausbilden der Fenster (10) ein anisotropes Trockenätzverfahren verwendet wird.

7. Verfahren nach einem der Ansprüche 1 bis 6,
bei dem vor dem Durchtrennen des Wafers (24) die Maskenschicht (4) entfernt wird.

8. Verfahren nach Anspruch 7,
bei dem die Maskenschicht (4) nach dem Abscheiden der Halbleiterstrukturen (2) mittels eines bezüglich der Halbleiterstrukturen (2) selektiven Ätzschrittes (14) entfernt wird.

9. Verfahren nach Anspruch 8,
bei dem zum Entfernen der Maskenschicht (4) nach dem Abscheiden der Halbleiterstrukturen (2) ein isotropes nasschemisches Ätzverfahren verwendet wird.

## Claims

1. Method for producing a plurality of edge emitting semiconductor laser chips (200), wherein:
- a mask layer (4) is applied to a substrate wafer (19),
- the mask layer (4) is provided with a plurality of windows (10) in which the main area (9) of the substrate wafer (19) is uncovered,
- a semiconductor layer sequence (18) based on Ga (Al, In) N is deposited onto the main area (9) of the substrate wafer (19) uncovered in the windows (10), with the result that edge emitting laser structures of identical type are produced in the windows (10), and
- the wafer (24) thus produced is singulated by means of severing between the edge emitting laser structures to form edge emitting semiconductor laser chips (200),
wherein the mask layer (4) has at least a thickness corresponding to the light-guiding region of the edge emitting laser structures, with the result that the laser mirror areas (8) of the edge emitting laser structures are in each case defined by two mutually opposite plane-parallel side areas (7) of the windows (10).

2. Method according to Claim 1,
wherein an SiO₂ or SiₓN₁₋ₓ layer is used as the mask layer (4).

3. Method according to either of Claims 1 and 2,
wherein the substrate wafer (19) has at least one epitaxially applied semiconductor layer (6) onto which the semiconductor layer sequence (18) is deposited in the windows (10).

4. Method according to Claim 3,
wherein the semiconductor layer (6) substantially consists of GaₓAl₁₋ₓN (0≤x≤1).

5. Method according to any of Claims 1 to 4,
wherein the semiconductor layer sequence has at least one semiconductor layer composed of Ga_{1-x-y}InₓAl_{y}N where 0≤x≤1, 0≤y≤1 and x+y<1.

6. Method according to any of Claims 1 to 5,
wherein an anisotropic dry etching method is used for forming the windows (10).

7. Method according to any of Claims 1 to 6,
wherein the mask layer (4) is removed before the wafer (24) is severed.

8. Method according to Claim 7,
wherein the mask layer (4) is removed after the deposition of the semiconductor structures (2) by means of an etching step (14) that is selective with respect to the semiconductor structures (2).

9. Method according to Claim 8,
wherein an isotropic wet-chemical etching method is used for removing the mask layer (4) after the deposition of the semiconductor structures (2).

## Revendications

1. Procédé de fabrication d'une pluralité de puces laser en semiconducteur (200) à émission par la tranche, selon lequel :
- une couche de masque (4) est appliquée sur une galette substrat (19),
- la couche de masque (4) est munie d'une pluralité de fenêtres (10) dans lesquelles est dégagée la surface principale (9) de la galette substrat (19),
- une série de couches en semiconducteur (18) à base de Ga(Al, In)N est déposée sur la surface principale (9) de la galette substrat (19) dégagée par les fenêtres (10) de manière à produire dans les fenêtres (10) des structures laser à émission par la tranche identiques, et
- la galette (24) ainsi produite étant divisée en puces laser en semiconducteur (200) à émission par la tranche individuelles par sectionnement entre les structures laser à émission par la tranche,
la couche de masque (4) présentant au moins une épaisseur qui correspond à la zone de passage de la lumière des structures laser à émission par la tranche, de sorte que les surfaces miroirs à laser (8) des structures laser à émission par la tranche sont à chaque fois définies par deux surfaces latérales (7) opposées l'une à l'autre et à faces planes et parallèles de la fenêtre (10).

2. Procédé selon la revendication 1, selon lequel la couche de masque (4) utilisée est une couche de SiO₂ ou de SiₓN₁₋ₓ.

3. Procédé selon l'une des revendications 1 ou 2, selon lequel la galette substrat (19) présente au moins une couche en semiconducteur (6) appliquée par épitaxie sur laquelle la série de couches en semiconducteur (18) est déposée dans les fenêtres (10).

4. Procédé selon la revendication 3, selon lequel la couche en semiconducteur (6) se compose pour l'essentiel de GaₓAl₁₋ₓN (0 ≤ x ≤ 1).

5. Procédé selon l'une des revendications 1 à 4, selon lequel la série de couches en semiconducteur présente au moins une couche en semiconducteur en Ga_{1-x-y}InₓAl_{y}N, avec 0 ≤ x < 1, 0 ≤ y < 1 et x+y < 1.

6. Procédé selon l'une des revendications 1 à 5, selon lequel un procédé de gravure anisotrope à sec est utilisé pour former les fenêtres (10).

7. Procédé selon l'une des revendications 1 à 6, selon lequel la couche de masque (4) est retirée avant de sectionner la galette (24).

8. Procédé selon la revendication 7, selon lequel la couche de masque (4) est retirée après la déposition des structures en semiconducteur (2) au moyen d'une étape de gravure (14) sélective pour les structures en semiconducteur (2).

9. Procédé selon la revendication 8, selon lequel un procédé de gravure isotrope chimique mouillé est utilisé pour retirer la couche de masque (4) après la déposition des structures en semiconducteur (2).
